# EUROPEAN PATENT SPECIFICATION

(11) **EP 3 456 162 B1**
(45) Date of publication and mention of the grant of the patent: **09.11.2022**
(21) Application number: 16901569.0
(22) Date of filing: 12.05.2016
(51) Int. Cl.: H05K 7/20, H05K 5/00

(54) **INTEGRATED ALUMINUM HEAT SINK, ELASTOMER ON TALC FILLED PP HOUSING FOR ELECTRONIC MODULE**
GEHÄUSE MIT TALKGEFÜLLTEM PP UND INTEGRIERTEM ALUMINIUMKÜHLKÖRPER MIT ELASTOMERSCHICHTEN FÜR ELEKTRONISCHES MODUL
DISSIPATEUR THERMIQUE EN ALUMINIUM INTÉGRÉ, ÉLASTOMÈRE SUR BOÎTIER PP CHARGÉ DE TALC POUR MODULE ÉLECTRONIQUE

(43) Date of publication of application: 20.03.2019
(73) Proprietor: Continental Automotive Technologies GmbH, 30165 Hannover (DE)
(72) Inventor: LIM, Kok Hee Abel, Singapore 416558 (SG); KONG, Hian Keat Jeff, Singapore 461219 (SG); ONG, Chye Keong, Singapore 670617 (SG)
(74) Representative: Continental Corporation
(86) International application number: PCT/IB2016/052715
(87) International publication number: WO 2017/194996

(56) References cited:
- WO-A1-2014/036096
- JP-A- 2004 048 862
- JP-A- 2011 091 167
- US-A- 5 212 627
- US-A1- 2003 132 770
- US-A1- 2004 115 991
- US-A1- 2007 183 128
- US-A1- 2007 183 128
- US-A1- 2009 009 969

## Description

The present application relates to an improved plastic housing with a heat sink for an electronic device. In particular, the plastic housing includes polypropylene (PP), which is filled with talc.

A wide range of thermal management methods is available for electronic devices. These thermal management methods can be categorized into two groups, namely active heat dissipation methods and passive heat dissipation methods.

The active heat dissipation methods use an energized mechanical device to remove heat. Examples of the mechanical device include a device for forcing air, a device for forcing liquid, and a solid-state heat pump. In contrast, the passive heat dissipation methods use a component to remove heat. Examples of the component include a heat sink, a heat spreader, and a thermal interface material. These heat dissipation methods often use a few parts or components to form a complete thermal management system.

WO 2007/122239 A1 describes a preparation of a polypropylene having a Melt Flow Rate (MFR) of 230 degree C, 2.16 kg from 45 to 150 grams/10 minutes. This polypropylene is suitable for preparing a living hinge.

WO 2014/036096 A1 describes a housing unit with a heat sink inserted into an opening in the cover. The heat sink has a lip which forms a seal between the heat sink and the cover.

US 2007/183128 A1 describes a heat sink inserted into an opening of a housing and fixed by a clip. A gasket s interposed between the heat sink and the housing.

US 5 212 627 A describes an overmoulded heat sink forming part of a housing for a connector.

The living hinge, frequently also referred to as a plastic hinge, provides an integrated and flexible connection between two pieces of a moulded polymer part, which allows the two pieces to bend along a line of the hinge.

It is an object of this application to provide an improved talc filled polypropylene (PP) plastic housing with a heat sink for an electronic device.

The application provides an improved housing unit for surrounding and protecting an electronic device of a vehicle.

The vehicle is used for transporting goods and people. The electronic device includes active components, such as microchips and transistors, which uses electricity and generates heat. In a general sense, the electronic device be used for other application, instead of the vehicle.

The housing unit includes a heat sink and a plastic housing.

The plastic housing includes a polypropylene (PP) material, which is filled with talc. The talc filled PP material allows the plastic housing to be rigid while having a low cost. The talc filled PP material has often has a low elongation or expansion. In other words, the plastic housing has low flexibility. Furthermore, the plastic housing is integrated with the heat sink or is formed around the heat sink such that the plastic housing is connected with the heat sink.

In use, the heat sink receives heat from the energized electronic device. The heat sink then dissipates this heat. The temperature of the heat sink also rises, wherein the heat sink then expands often slightly.

Furthermore, the housing unit includes one or more elastomer layers. The elastomer layer is placed next to an area of the heat sink such that the elastomer layer is placed between a part of the heat sink and a part of the plastic housing. The elastomer layer is also in contact with the heat sink part and in contact with the plastic housing part.

The arrangement of the elastomer layers prevents the plastic housing from receiving an expansion force of the heated heat sink. In other words, the elastomer layers absorb the expansion of the heated heat sink such that the plastic housing does not receive any or little force from the enlarged heat sink.

This arrangement of the housing unit advantageously provides the housing unit with a low cost due to its talc-filled PP material while using the elastomer layer to accommodate the low flexibility of the talc-filled PP material.

The housing unit can have several additional features.

The heat sink often includes a contact area for touching the electronic device in order to receive heat by conduction.

The plastic housing also often includes a first plastic housing portion with a second plastic housing as well as a plastic hinge being integrally connected to the first plastic housing portion and to second plastic housing. These parts can be produced in a single step using injection moulding to save cost.

The first plastic housing portion and the second plastic housing portion can include a plastic locking mechanism for locking the first plastic housing portion to the second plastic housing portion. The locking mechanism can attach the first plastic housing portion to the second plastic housing portion after an electronic device is inserted into the plastic housing.

The first plastic housing portion can include an opening for receiving easily the heat sink.

A rim of the opening can also include at least one groove part for receiving and gripping the heat sink.

The second plastic housing portion can also include a service door or cover as well as a plastic hinge for connecting the service door to a part of the second plastic housing portion. The second plastic housing portion with the service door and the plastic hinge can be produced in one step using injection moulding to save cost. The door allows easy insertion of a component, such as a battery, into the housing unit.

The service door and a part of the second plastic housing portion can include a plastic locking mechanism for locking the service door to the part of the second plastic housing portion.

The plastic housing is often formed using insert moulding. In the insert moulding, the heat sink is inserted into a mould. After this, a moulding material is injected into the mould, often at a high temperature, for forming the plastic housing.

The elastomer layer is often provided on the heat sink using over-moulding. The over-moulding is a form of insert moulding. The heat sink is placed in a mould, wherein a part of the mould allows a elastomer material to be placed on one or more parts of the heat sink to form the elastomer layers.

The heatsink is often formed from a metal using die-casting.

The application also provides a method of producing a housing unit for an electronic device. The method includes a step of providing a heat sink. After this, an elastomer layer is provided on the heat sink. A plastic housing is then provided or is formed from a polypropylene (PP) material that is filled with talc. This is done such that the elastomer layer is provided between the one or more parts of the heat sink and the plastic housing. The elastomer layer is also provided such that it prevents the plastic housing from receiving an expansion force of the heated heat sink.

The method can include several additional steps. The heat sink can be provided from a metal using die-casting. The elastomer layer can be provided on the heat sink using over-moulding. The plastic housing can be provided using insert moulding.

In other words, the application provides a plastic housing unit that includes a plastic housing, a heat sink, and a layer of elastomer. The elastomer layer is provided between the heat sink and the plastic housing. The plastic housing includes mainly polypropylene (PP), which is filled with talc, for lowering material cost of the plastic housing. The heat sink includes a metal, such as aluminium, for providing a passive means of heat dissipation, which is often cheaper than an active heat dissipation means.

In use, the heat sink contacts the electronic device and it acts to dissipate heat from the electronic device. The heat sink receives heat energy from the electronic device, which then transfers the heat energy to another media, such as external air.

The plastic housing unit is adapted such that, when the heat sink receives this heat energy, the heat sink expands slightly. The expanded heat sink then exerts a compressive force on elastomer layer such that the plastic housing does not experience any force or a little force from the expanded heat sink. In short, the elastomer layer absorbs the thermal expansion of the heat sink. Without this absorption, the thermal expansion can damage the plastic housing. Moreover, the elastomer layer prevents transfer of thermal energy from the heat sink to the plastic housing.

This is different from other housing units, which are produced by insertion moulding, wherein a heat sink is placed into a cavity of a mould. The heat sink does not have an elastic layer. A plastic material is then injected into the mould to surround the heat sink to form a plastic housing. When this heat sink receives heat energy, it expands and it essentially exerts its entire force from the thermal expansion on the plastic housing.

This plastic housing unit of the application has an advantage of providing low cost while achieving desired heat dissipation of the electronic device.
- Fig. 1: illustrates a front perspective view of an improved plastic housing unit, which includes a plastic housing portion and a heat sink,
- Fig. 2: illustrates a front perspective view of the heat sink of the plastic housing unit of Fig. 1,
- Fig. 3: illustrates a rear perspective view of the heat sink of Fig. 2,
- Fig. 4: illustrates a front perspective view of the heat sink of Fig. 2 with a layer of elastomer,
- Fig. 5: illustrates a rear perspective view of the heat sink of Fig. 4,
- Fig. 6: illustrates a front perspective view of a first plastic housing portion of the plastic housing of Fig. 1,
- Fig. 7: illustrates a rear perspective view of the first plastic housing portion of Fig. 6, and
- Fig. 8: illustrates a cross-sectional view of the heat sink of Fig. 1.

In the following description, details are provided to describe embodiments of the application. It shall be apparent to one skilled in the art, however, that the embodiments may be practiced without such details.

Some parts of the embodiment have similar parts. The similar parts may have the same names or similar part numbers. The description of one similar part also applies by reference to another similar parts, where appropriate, thereby reducing repetition of text without limiting the disclosure.

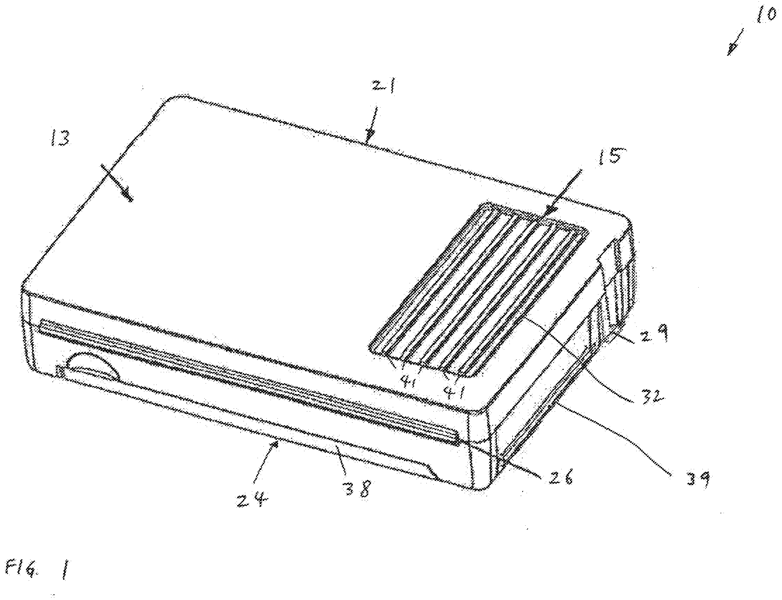

Fig. 1 shows a plastic housing unit 10 for an electronic device.

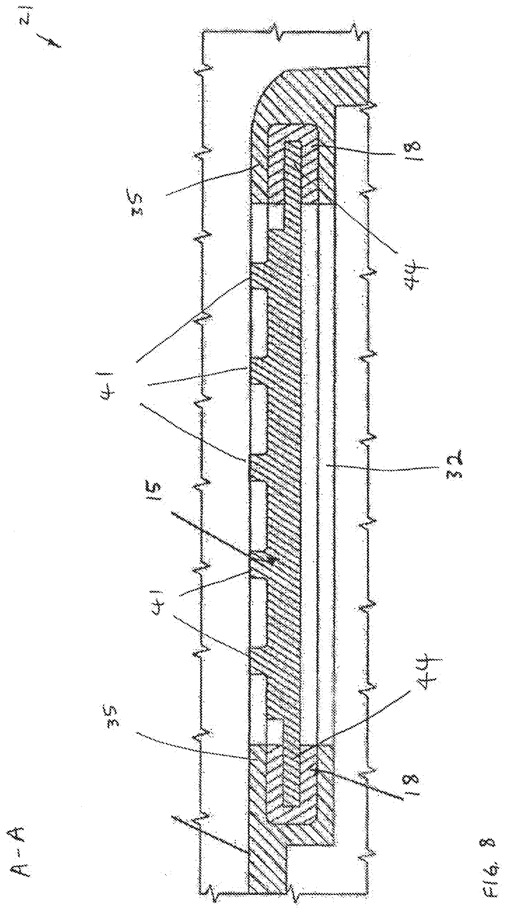

Referring to Figs. 1, 4 and 5, the plastic housing unit 10 includes a plastic housing 13, a heat sink 15, and a layer 18 of elastomer. The heat sink 15 is attached to the plastic housing 13 while the elastomer layer 18 is placed between a part of the plastic housing 13 and a part of the heat sink 15. An outer surface of the elastomer layer 18 is placed next to a part for the plastic housing 13 while an inner surface of the elastomer layer 18 is placed to a part of the heat sink 15, as better seen in Fig. 8.

As better seen in Fig. 1, the plastic housing 13 comprises a plastic first housing portion 21 with a plastic second housing portion 24 and a plastic housing portion living hinge 26. The living hinge 26 is also simply called a plastic hinge.

Each of the first housing portion 21 and the second housing portion 24 has a shape of an open rectangular box with a rim. The housing portion living hinge 26 integrally joins the rim of the first housing portion 21 with the rim of the second housing portion 24 such that the first housing portion 21 or the second housing portion 24 can rotate about a longitudinal axis of the housing portion living hinge 26.

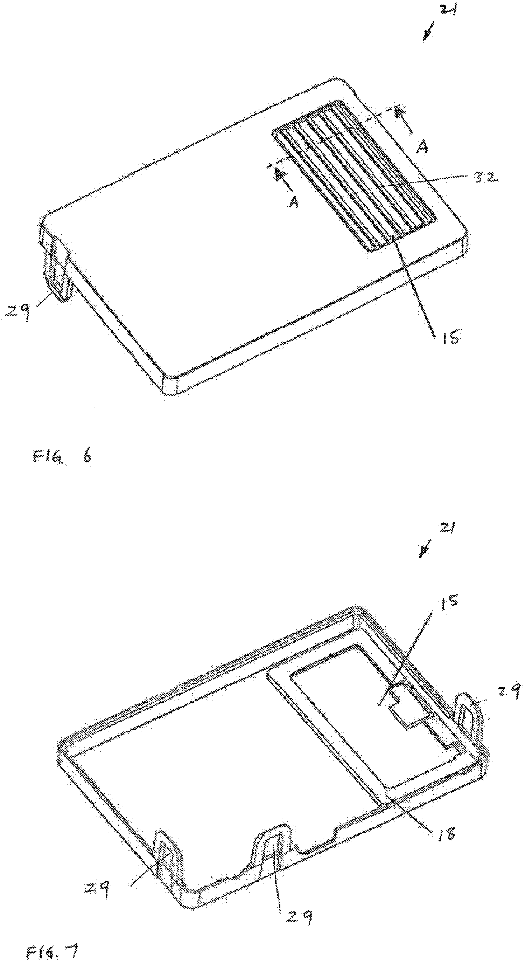

In detail, as better seen in Figs. 6, 7, and 8, the first housing portion 21 includes several plastic first housing portion locking elements 29 and a heat sink opening 32. The heat sink opening 32 is located at an inner part of the first housing portion 21 while the first housing portion locking elements 29 are located at the rim of the first housing portion 21.

As better seen in Fig. 8, the heat sink opening 32 includes a rim or edge 35 with a groove. The groove extends along the entire rim 35 of the heat sink opening 32.

Referring to Fig. 1, the second housing portion 24 includes several plastic second housing portion locking elements, which are located along the rim of the second housing portion 24 and which are adapted for locking with the first housing portion locking elements 29. The second housing portion locking elements are not shown in the Figures.

The second housing portion 24 also includes a plastic service door 38 or cover and a plastic door living hinge 39, which integrally joins the service door 38 to another part of the second housing portion 24.

The plastic service door 38 includes a door locking element. A part of the second housing portion 24 also includes a corresponding door locking element, which is adapted for locking with the door locking element of the service door 38. These locking elements are not shown in the Figures.

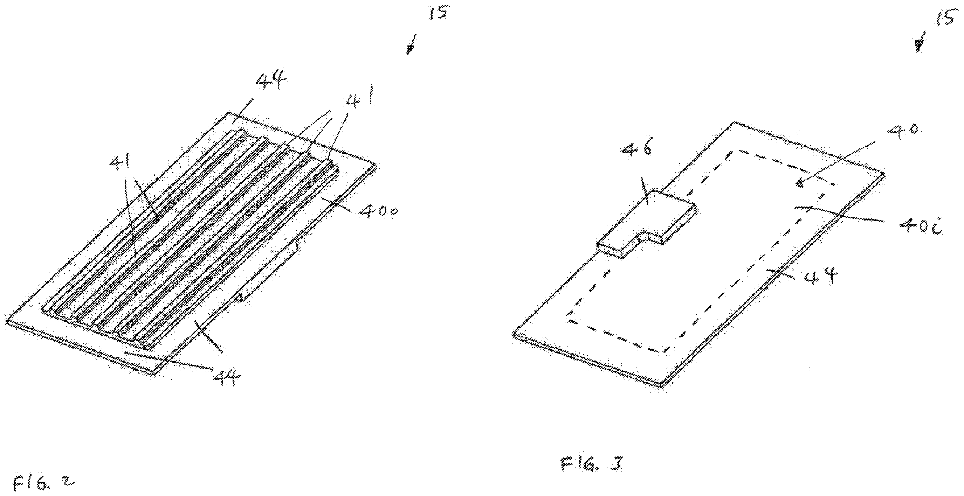

Referring to the heat sink 15, as better seen in Figs. 2 and 3, the heat sink 15 includes a thin and generally rectangular block 40, several parallel fin element portions 41, a housing portion contact part 44, and an electronic device contact area 46. The contact part 44 is also called a shoulder.

In particular, the rectangular block 40 comprises an outer major rectangular surface 40o with an inner major rectangular surface 40i and four side minor rectangular surfaces. The outer major rectangular surface 40o is shown in Fig. 2 while the inner major rectangular surface 40i is shown in Fig. 3. The side minor rectangular surfaces are not shown in the Figures. The inner major surface 40i is located essentially parallel to the outer major surface 40o. The four side minor rectangular surfaces form a rectangular loop, which joins the outer major rectangular surface 40o to the inner major rectangular surface 40i.

Each fin element portion 41 comprises an elongated protrusion. The fin element portions 41 are located on the outer major surface 40i.

The electronic device contact area 46 is located on the inner major surface 40i.

The housing portion contact part 44 includes an elongated protrusion with a generally rectangular cross-section. The elongated protrusion is located next to the four side minor rectangular surfaces and is joined integrally to the side minor rectangular surfaces. In short, the elongated protrusion surrounds the rectangular block 40.

As seen in Fig. 8, the heat sink 15 is inserted into the heat sink opening 32 of the first housing portion 21 such that the housing portion contact part 44 of the heat sink 15 is inserted into the groove of the rim 35 of the heat sink opening 32.

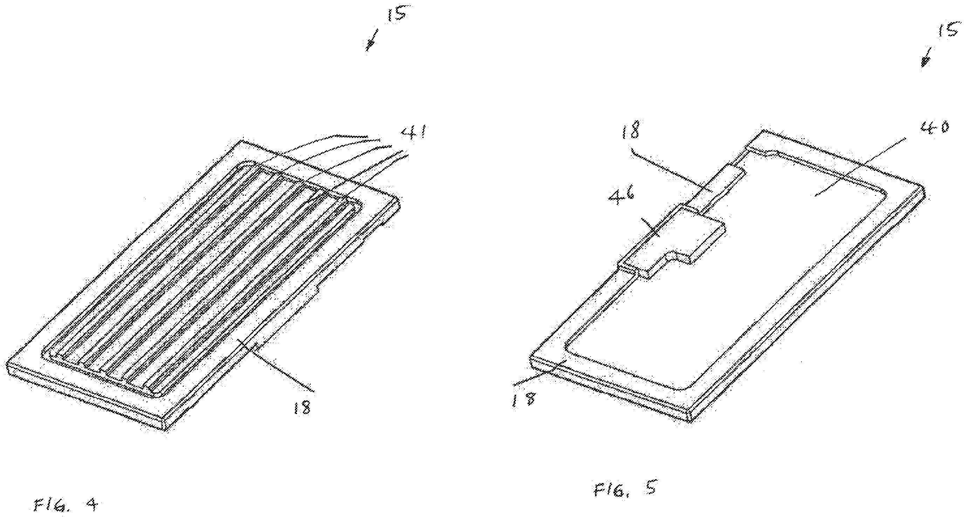

Referring to the elastomer layer 18, as seen in Figs. 4, 5, and 8, the elastomer layer 18 is located on an outer surface of the housing portion contact part 44. The elastomer layer 18 is also located between the housing portion contact part 44 and the groove of the heat sink opening rim 35. The inner surface of the elastomer layer 18 is also located next to the housing portion contact part 44 while the outer surface of the elastomer layer 18 is located next to the groove of the heat sink opening rim 35, as seen in Fig. 8. In other words, the elastomer layer 18 is provided to separate the housing portion contact part 44 from the groove of the heat sink opening rim 35.

In relation to material, the heat sink 15 is produced from aluminium using die-casting while the plastic housing 13 is produced from polypropylene (PP), which is filled with talc using insert moulding.

In use, the plastic housing unit 10 is used for enclosing an electronic device, wherein the plastic housing unit 10 serves to protect and to dissipate heat from the electronic device.

The electronic device is intended for used in a vehicle, although it can also be used for other applications.

The groove of the heat sink opening rim 35 of the first housing portion 21 is used for holding the heat sink 15.

The heat sink opening 32 is used for receiving the heat sink 15 while allowing the heat sink fin element portions 41 to be exposed to external air.

The electronic device contact area 46 then contacts a heat dissipation area of the vehicle electronic device and receives heat from the electronic device, especially when the electronic device is energised.

The protrusions of the fin element portions 41 act to increase surface area of the heat sink 15 for improving efficiency of transfer of the heat to external air.

The elastomer layer 18 acts as a heat barrier or shield between the heat sink 15 and the first housing portion 21. The elastomer layer 18 also acts as a cushion for preventing a thermal expansion of the heating heat sink 15 from exerting a force on the first housing portion 21. When the heat sink 15 is heated, it expands slightly. The elastomer layer 18 then absorbs this expansion such that the first housing portion 21 does not experience any force or only a little force from the expanded heat sink 15. Without this elastomer layer 18, this expansion can damage the first housing portion 21. In short, the elastomer layer absorbs the thermal expansion of the heat sink 15.

A method for producing the 10 is described below.

The method includes a step of producing the heat sink 15 from aluminium using die-casting.

A step of providing the elastomer layer 18 on the heat sink 15 using over-moulding to form a heat sink sub-assembly is then performed. This step includes placing the heat sink 15 in a mould. The elastomer layer 18 is then placed on the housing portion contact part 44.

A further step of integrating the heat sink sub-assembly with the plastic housing 13 using insert moulding process is later performed. This further step includes placing the heat sink sub-assembly in a further mould. Molten polypropylene (PP), which is filled with talc, is then injected into the further mould to form the plastic housing 13, which encloses the heat sink 15. The fin element portion 41 are exposed or are not covered with the talc filled PP while the heat sink opening rim 35 covers and encloses the heat sink housing portion contact part 44. After cooling, the plastic housing 13, which is integrated with the heat sink 15, is removed from the mould.

This integration of the heat sink 15 with the plastic housing 13 provides several benefits.

The integration of the talc filled PP plastic housing 13 with the heat sink 15 is done to provide a single piece without any screws, thereby allowing for production of the plastic housing 13 with the heat sink 15 at a reduced cost.

The heat sink 15 allows for efficient heat transfer, wherein its surface area is enlarged for improving heat dissipation with ambient air.

The elastomer layer reduces incompatibility of material between the plastic housing 13 and the heat sink 15, especially in high heat condition.

The integration of the heat sink 15 with the plastic housing 13 allows for a seamless design for meeting product design requirement.

The talc filled PP material of the plastic housing 13 acts to reduce cost of the plastic housing 13. scope of the embodiments should be determined by the claims.

### REFERENCE NUMBERS

- 10: plastic housing unit
- 13: plastic housing
- 15: heat sink
- 18: elastomer layer
- 21: first housing portion
- 24: second housing portion
- 26: housing portion living hinge
- 29: first housing portion locking element
- 32: heat sink opening
- 35: rim
- 38: service door
- 39: door living hinge
- 40: rectangular block
- 40o: outer major rectangular surface
- 40i: inner major rectangular surface
- 41: fin element portion
- 44: housing portion contact part
- 46: electronic device contact area

## Claims

1. A housing unit (10) for an electronic device, the housing unit (10) comprising
a heat sink (15) for dissipating heat from the electronic device, and
a plastic housing (13) which comprises talc filled polypropylene (PP) material for connecting to the heat sink,
**characterized in that**
the housing unit (10) further comprises at least one elastomer layer (18) being provided between at least one part of the heat sink (15) and at least one part of the plastic housing (13),
the elastomer layer (18) is adapted for preventing the plastic housing (13) from receiving an expansion force of the heat sink (15), and
the plastic housing (13) and a heat sink sub-assembly, which comprises the heat sink (15) and the at least one elastomer layer (18), are provided as a single piece.

2. The housing unit (10) according to claim 1, wherein
the heat sink (15) comprises an electronic device contact area (46).

3. The housing unit (10) according to claim 1, wherein
the plastic housing (13) comprises a first plastic housing portion (21) with a second plastic housing portion (24), and a plastic hinge (26) being integrally connected to the first plastic housing portion (21) and to second plastic housing portion (24).

4. The housing unit (10) according to claim 3, wherein the first plastic housing portion (21) and the second plastic housing portion (24) comprise a plastic locking mechanism for locking the first plastic housing portion (21) to the second plastic housing portion (24).

5. The housing unit (10) according to claim 3, wherein the first plastic housing portion (21) comprises an opening (32) that receives the heat sink (15).

6. The housing unit (10) according to claim 5, wherein a rim (35) of the opening (32) comprises at least one groove part that receives the heat sink (15).

7. The housing unit (10) according to claim 3, wherein the second plastic housing portion (24) comprises a service door (38) and a plastic hinge (39) for connecting the service door (38) to a part of the second plastic housing portion (24).

8. The housing unit (10) according to claim 7, wherein the service door (38) and a part of the second plastic housing portion (24) comprise a plastic locking mechanism for locking the service door (38) to the part of the second plastic housing portion (24).

9. The housing unit (10) according to claim 1, wherein the plastic housing (13) is integrated with the heat sink (15) and the at least one elastomer layer (18) using insert moulding.

10. The housing unit (10) according to claim 1, wherein the elastomer layer (18) is provided on the heat sink (15) using over-moulding.

11. The housing unit (10) according to claim 1, wherein the heat sink (15) is formed from a metal using die-casting.

12. A method of producing a housing unit (10) for an electronic device, the method comprising
providing a heat sink (15),
providing at least one elastomer layer (18) on at least one part of the heat sink (15) to form a heatsink sub-assembly,
providing a plastic housing (13) which comprises talc filled polypropylene (PP) material,
integrating the heat sink sub-assembly with the plastic housing (13) such that a single piece is provided,
wherein the elastomer layer (18) is provided between the at least one part of the heat sink (15) and the plastic housing (13), and
wherein the elastomer layer (18) prevents the plastic housing (13) from receiving an expansion force of the heat sink (15).

13. The method according to claim 12, wherein
the heat sink (15) is provided from a metal using die-casting.

14. The method according to claim 12, wherein
the elastomer layer (18) is provided on the heat sink (15) using over-moulding.

15. The method according to claim 12, wherein
the plastic housing (13) is integrated with the heat sink (15) comprising the at least one elastomer layer (18) using insert moulding.

## Patentansprüche

1. Gehäuseeinheit (10) für eine elektronische Vorrichtung, die Gehäuseeinheit (10) Folgendes aufweisend
einen Kühlkörper (15) zum Ableiten von Wärme aus der elektronischen Vorrichtung und
ein Kunststoffgehäuse (13), das talkgefülltes Polypropylen-Material (PP-Material) zum Verbinden mit dem Kühlkörper aufweist,
**dadurch gekennzeichnet, dass**
die Gehäuseeinheit (10) weiterhin mindestens eine Elastomerschicht (18) aufweist, die zwischen mindestens einem Teil des Kühlkörpers (15) und mindestens einem Teil des Kunststoffgehäuses (13) bereitgestellt ist,
die Elastomerschicht (18) eingerichtet ist, um zu verhindern, dass das Kunststoffgehäuse (13) eine Dehnungskraft des Kühlkörpers (15) aufnimmt, und
das Kunststoffgehäuse (13) und eine Kühlkörper-Subeinheit, die den Kühlkörper (15) und die mindestens eine Elastomerschicht (18) aufweist, als ein einziges Stück bereitgestellt sind.

2. Gehäuseeinheit (10) nach Anspruch 1, wobei der Kühlkörper (15) eine Kontaktfläche (46) mit der elektronischen Vorrichtung aufweist.

3. Gehäuseeinheit (10) nach Anspruch 1, wobei das Kunststoffgehäuse (13) einen ersten Kunststoffgehäuseabschnitt (21) mit einem zweiten Kunststoffgehäuseabschnitt (24) und ein Kunststoffscharnier (26) aufweist, das integral mit dem ersten Kunststoffgehäuseabschnitt (21) und mit dem zweiten Kunststoffgehäuseabschnitt (24) verbunden ist.

4. Gehäuseeinheit (10) nach Anspruch 3, wobei der erste Kunststoffgehäuseabschnitt (21) und der zweite Kunststoffgehäuseabschnitt (24) einen Kunststoffverriegelungsmechanismus zum Verriegeln des ersten Kunststoffgehäuseabschnitts (21) an dem zweiten Kunststoffgehäuseabschnitt (24) aufweisen.

5. Gehäuseeinheit (10) nach Anspruch 3, wobei der erste Kunststoffgehäuseabschnitt (21) eine Öffnung (32) aufweist, die den Kühlkörper (15) aufnimmt.

6. Gehäuseeinheit (10) nach Anspruch 5, wobei ein Rand (35) der Öffnung (32) mindestens einen Nutteil aufweist, der den Kühlkörper (15) aufnimmt.

7. Gehäuseeinheit (10) nach Anspruch 3, wobei der zweite Kunststoffgehäuseabschnitt (24) eine Zugangsklappe (38) und ein Kunststoffscharnier (39) zum Verbinden der Zugangsklappe (38) mit einem Teil des zweiten Kunststoffgehäuseabschnitts (24) aufweist.

8. Gehäuseeinheit (10) nach Anspruch 7, wobei die Zugangsklappe (38) und ein Teil des zweiten Kunststoffgehäuseabschnitts (24) einen Kunststoffverriegelungsmechanismus zum Verriegeln der Zugangsklappe (38) an dem Teil des zweiten Kunststoffgehäuseabschnitts (24) aufweisen.

9. Gehäuseeinheit (10) nach Anspruch 1, wobei das Kunststoffgehäuse (13) unter Verwendung von Insert-Formen mit dem Kühlkörper (15) und der mindestens einen Elastomerschicht (18) integriert ist.

10. Gehäuseeinheit (10) nach Anspruch 1, wobei die Elastomerschicht (18) unter Verwendung von Überspritzen auf dem Kühlkörper (15) bereitgestellt wird.

11. Gehäuseeinheit (10) nach Anspruch 1, wobei der Kühlkörper (15) unter Verwendung von Druckgießen aus einem Metall ausgebildet wird.

12. Verfahren zum Herstellen einer Gehäuseeinheit (10) für eine elektronische Vorrichtung, das Verfahren Folgendes aufweisend
Bereitstellen eines Kühlkörpers (15),
Bereitstellen mindestens einer Elastomerschicht (18) auf mindestens einem Teil des Kühlkörpers (15), um eine Kühlkörper-Subeinheit auszubilden,
Bereitstellen eines Kunststoffgehäuses (13), das talkgefülltes Polypropylen-Material (PP-Material) aufweist,
Integrieren der Kühlkörper-Subeinheit mit dem Kunststoffgehäuse (13), so dass ein einziges Stück bereitgestellt wird,
wobei die Elastomerschicht (18) zwischen dem mindestens einen Teil des Kühlkörpers (15) und dem Kunststoffgehäuse (13) bereitgestellt wird und
wobei die Elastomerschicht (18) verhindert, dass das Kunststoffgehäuse (13) eine Dehnungskraft des Kühlkörpers (15) aufnimmt.

13. Verfahren nach Anspruch 12, wobei der Kühlkörper (15) unter Verwendung von Druckgießen aus einem Metall bereitgestellt wird.

14. Verfahren nach Anspruch 12, wobei die Elastomerschicht (18) unter Verwendung von Überspritzen auf dem Kühlkörper (15) bereitgestellt wird.

15. Verfahren nach Anspruch 12, wobei das Kunststoffgehäuse (13) unter Verwendung von Insert-Formen mit dem Kühlkörper (15) integriert ist, der die mindestens eine Elastomerschicht (18) aufweist.

## Revendications

1. Unité formant boîtier (10) pour un dispositif électronique, l'unité formant boîtier (10) comprenant
un dissipateur thermique (15) pour dissiper la chaleur du dispositif électronique, et
un boîtier en plastique (13) qui comprend un matériau à base de polypropylène (PP) chargé de talc pour se rattacher au dissipateur thermique,
**caractérisée en ce que**
l'unité formant boîtier (10) comprend en outre au moins une couche élastomère (18) disposée entre au moins une partie du dissipateur thermique (15) et au moins une partie du boîtier en plastique (13),
la couche élastomère (18) est adaptée pour empêcher le boîtier en plastique (13) de recevoir une force de dilatation du dissipateur thermique (15), et
le boîtier en plastique (13) et un sous-ensemble dissipateur thermique, qui comprend le dissipateur thermique (15) et l'au moins une couche élastomère (18), sont obtenus d'une seule pièce.

2. Unité formant boîtier (10) selon la revendication 1, dans laquelle le dissipateur thermique (15) comprend une zone de contact de dispositif électronique (46).

3. Unité formant boîtier (10) selon la revendication 1, dans laquelle le boîtier en plastique (13) comprend une première portion de boîtier en plastique (21) avec une deuxième portion de boîtier en plastique (24), et une charnière en plastique (26) intégralement rattachée à la première portion de boîtier en plastique (21) et à la deuxième portion de boîtier en plastique (24).

4. Unité formant boîtier (10) selon la revendication 3, dans laquelle la première portion de boîtier en plastique (21) et la deuxième portion de boîtier en plastique (24) comprennent un mécanisme de verrouillage en plastique pour verrouiller la première portion de boîtier en plastique (21) sur la deuxième portion de boîtier en plastique (24).

5. Unité formant boîtier (10) selon la revendication 3, dans laquelle la première portion de boîtier en plastique (21) comprend une ouverture (32) qui reçoit le dissipateur thermique (15).

6. Unité formant boîtier (10) selon la revendication 5, dans laquelle un bord (35) de l'ouverture (32) comprend au moins une partie de sillon qui reçoit le dissipateur thermique (15).

7. Unité formant boîtier (10) selon la revendication 3, dans laquelle la deuxième portion de boîtier en plastique (24) comprend une porte de service (38) et une charnière en plastique (39) pour rattacher la porte de service (38) à une partie de la deuxième portion de boîtier en plastique (24).

8. Unité formant boîtier (10) selon la revendication 7, dans laquelle la porte de service (38) et une partie de la deuxième portion de boîtier en plastique (24) comprennent un mécanisme de verrouillage en plastique pour verrouiller la porte de service (38) sur la partie de la deuxième portion de boîtier en plastique (24).

9. Unité formant boîtier (10) selon la revendication 1, dans laquelle le boîtier en plastique (13) est intégré au dissipateur thermique (15) et l'au moins une couche élastomère (18) par moulage par insertion.

10. Unité formant boîtier (10) selon la revendication 1, dans laquelle la couche élastomère (18) est appliquée sur le dissipateur thermique (15) par surmoulage.

11. Unité formant boîtier (10) selon la revendication 1, dans laquelle le dissipateur thermique (15) est formé à partir d'un métal par moulage sous pression.

12. Procédé de production d'une unité formant boîtier (10) pour un dispositif électronique, le procédé comprenant
l'obtention d'un dissipateur thermique (15),
l'application d'au moins une couche élastomère (18) sur au moins une partie du dissipateur thermique (15) pour former un sous-ensemble dissipateur therm ique,
l'obtention d'un boîtier en plastique (13) qui comprend un matériau à base de polypropylène (PP) chargé de talc,
l'intégration du sous-ensemble dissipateur thermique avec le boîtier en plastique (13) de telle sorte qu'une seule pièce est obtenue,
dans lequel la couche élastomère (18) est disposée entre l'au moins une partie du dissipateur thermique (15) et le boîtier en plastique (13), et
dans lequel la couche élastomère (18) empêche le boîtier en plastique (13) de recevoir une force de dilatation du dissipateur thermique (15).

13. Procédé selon la revendication 12, dans lequel
le dissipateur thermique (15) est obtenu à partir d'un métal par moulage sous pression.

14. Procédé selon la revendication 12, dans lequel
la couche élastomère (18) est appliquée sur le dissipateur thermique (15) par surmoulage.

15. Procédé selon la revendication 12, dans lequel
le boîtier en plastique (13) est intégré avec le dissipateur thermique (15) comprenant l'au moins une couche élastomère (18) par moulage par insertion.
